# EUROPEAN PATENT SPECIFICATION

(11) **EP 3 815 806 B1**
(45) Date of publication and mention of the grant of the patent: **29.11.2023**
(21) Application number: 19826076.2
(22) Date of filing: 25.06.2019
(51) Int. Cl.: B21C 3/02, C01B 32/25, C23C 16/27, C30B 29/04

(54) **TOOL WITH THROUGH HOLE COMPRISING A DIAMOND COMPONENT**
WERKZEUG MIT DURCHGANGSBOHRUNG UMFASSEND EINER DIAMANTKOMPONENTE
OUTIL DOTÉ DE TROU TRAVERSANT COMPRENANT UN COMPOSANT EN DIAMANT

(30) Priority: 27.06.2018 JP 2018121764
(43) Date of publication of application: 05.05.2021
(73) Proprietor: Sumitomo Electric Hardmetal Corp., Itami-shi, Hyogo 664-0016 (JP); SUMITOMO ELECTRIC INDUSTRIES, LTD., Osaka-shi, Osaka 541-0041 (JP)
(72) Inventor: NOHARA, Takuya, Itami-shi, Hyogo 664-0016 (JP); UEDA, Akihiko, Itami-shi, Hyogo 664-0016 (JP); KOBAYASHI, Yutaka, Itami-shi, Hyogo 664-0016 (JP); NISHIBAYASHI, Yoshiki, Osaka-shi, Osaka 541-0041 (JP)
(74) Representative: Boult Wade Tennant LLP
(86) International application number: PCT/JP2019/025108
(87) International publication number: WO 2020/004373

(56) References cited:
- WO-A1-03/101638
- WO-A1-2016/068244
- WO-A1-2016/068244
- JP-A- H07 214 139
- JP-A- 2003 260 510
- JP-A- 2003 260 510
- JP-A- 2014 148 463
- JP-A- 2014 148 463
- US-A- 1 624 027
- US-A1- 2005 076 897
- US-B2- 8 176 765

## Description

### TECHNICAL FIELD

The present invention relates to a tool with a through hole.

### BACKGROUND ART

Since diamond has extremely high hardness, it is used in wear-resistant tools such as a die, a water jet nozzle, and a wire guide.

Japanese Patent Laying-Open No. 5-169131 (PTL 1) discloses a drawing die. The drawing die includes a polycrystalline CVD diamond layer which is provided with a through hole and attached to a support.

Document US 2005/076897 A1 shows a tool with a through hole comprising a diamond component, and forms the basis for the preamble of claim 1.

### CITATION LIST

### PATENT LITERATURE

PTL 1: Japanese Patent Laying-Open No. 5-169131

### SUMMARY OF INVENTION

A tool with a through hole according to the present invention is according to claim 1.

A diamond component according to a reference example is provided with a through hole, and when the length of the diamond component along a center line of the through hole is denoted as L1 and the maximum value of a diameter of a circle having the same area as a region surrounded by an outer edge of the diamond component in a cross section having the center line as a normal line is denoted as M1, the ratio L1/M1 between L1 and M1 is 0.8 or more.

A diamond material according to a reference example is used in a tool with a through hole. In the case where a through hole is formed in the diamond material, and when the length of the diamond material along a center line of the through hole is denoted as L2 and the maximum value of a diameter of a circle having the same area as a cross section of the diamond material having the center line as a normal line is denoted as M2, the ratio L2/M2 between L2 and M2 is 0.8 or more.

A diamond material according to a reference example is used in a tool with a through hole, the diamond material is made of single crystal diamond, a first surface of the diamond material is a (111) plane, a (100) plane, or a (110) plane, and when the length of the diamond material along a normal line of the first surface is denoted as L2 and the maximum value of a diameter of a circle having the same area as a cross section of the diamond material parallel to the first surface is denoted as M2, the ratio L2/M2 between L2 and M2 is 0.8 or more.

### BRIEF DESCRIPTION OF DRAWINGS

Fig. 1 is a plan view of a tool with a through hole according to an embodiment of the present invention;
Fig. 2 is a cross-sectional view taken along line X1-X1 of the tool with a through hole illustrated in Fig. 1;
Fig. 3 is a cross-sectional view taken along line X2-X2 of the tool with a through hole illustrated in Fig. 2;
Fig. 4 is a view illustrating a region S1 surrounded by the outer profile of a diamond component illustrated in Fig. 3;
Fig. 5 is a diagram illustrating a circle having the same area as the region S 1 illustrated in Fig. 4;
Fig. 6 is a cross-sectional view of a conventional tool with a through hole according to the prior art;
Fig. 7 is a plan view of a diamond component according to a reference example;
Fig. 8 is a cross-sectional view taken along line X3-X3 of the diamond component illustrated in Fig. 7;
Fig. 9 is a plan view of a diamond material according to a reference example;
Fig. 10 is a cross-sectional view taken along line X4-X4 of the diamond material illustrated in Fig. 9;
Fig. 11 is a schematic view of a cutting jig and a cutting assist jig used in laser cutting of a diamond material; and
Fig. 12 is a top view of the cutting jig and the cutting assist jig illustrated in Fig. 11.

### DETAILED DESCRIPTION

### [Problem to be Solved by the Present Invention]

In recent years, the strength of a wire-drawing material is increasing, and it is required to process such material at high efficiency. When a conventional die is used to process a high-strength wire rod at high efficiency, the die is worn down fast, which shortens the tool life.

Therefore, an object of the present invention is to provide a tool with a through hole which may have a longer tool life even if it is used to process a high-strength wire rod at high efficiency, a diamond component which may be used in the tool with a through hole, and a diamond material.

### [Advantageous Effect of the Present Invention]

According to an embodiment described above, the tool with a through hole may have a longer tool life even if it is used to process a high-strength wire rod at high efficiency.

### [Description of Embodiments of the Present Invention]

First, embodiments of the present invention are described hereinafter.

A tool with a through hole according to the present invention is according to claim 1.

The tool with a through hole may have a longer tool life even if it is used to process a high-strength wire rod at high efficiency.

L1 is preferably 0.5 mm or more and 50 mm or less, and M1 is preferably 0.5 mm or more and 31 mm or less. Thus, the diamond component is excellent in wear resistance.

The minimum diameter of the through hole is preferably 0.001 mm or more and 15 mm or less. The through hole may be made to cope with various diameters, which makes the tool with the through hole highly convenient.

It is preferable that an angle α formed between a surface of the diamond component on an inlet side of the through hole and a surface of the diamond component on an outlet side of the through hole is 0° or more and 1° or less. Thereby, the diamond component is unlikely to fall down when the diamond component is disposed in a recess of the base during the manufacture of the tool with a through hole, which makes it possible to manufacture the tool with a through hole efficiently.

It is preferable that the diamond component is made of synthetic single crystal diamond. The synthetic single crystal diamond may be easily processed into a desired shape, which makes it possible to manufacture the tool with a through hole efficiently.

The synthetic single crystal diamond preferably contains nitrogen atoms at a concentration of 0.01 ppb or more and 3000 ppm or less. Thereby, the wear resistance of the tool with a through hole is improved. Further, the synthetic single crystal diamond is unlikely to creak when it is used to manufacture the tool with a through hole.

The synthetic single crystal diamond preferably contains boron atoms at a concentration of 0.5 ppb or more and 10000 ppm or less. Thereby, the wear resistance of the tool with a through hole is improved. Further, the synthetic single crystal diamond is unlikely to creak when it is used to manufacture the tool with a through hole.

The synthetic single crystal diamond preferably contains silicon atoms at a concentration of 0.0001 ppb or more and 10000 ppm or less. Thereby, the wear resistance of the tool with a through hole is improved. Further, the synthetic single crystal diamond is unlikely to creak when it is used to manufacture the tool with a through hole.

The synthetic single crystal diamond preferably contains impurity atoms other than nitrogen atoms, boron atoms and silicon atoms at a total concentration of 0.5 ppb or more and 10000 ppm or less. Thereby, the wear resistance of the tool with a through hole is improved. Further, the synthetic single crystal diamond is unlikely to creak when it is used to manufacture the tool with a through hole.

The phase difference generated when the synthetic single crystal diamond is irradiated with circularly polarized light is preferably 0.1 nm or more and 200 nm or less. Thereby, it is possible to suppress the occurrence of chipping in the diamond component during the use of the tool with a through hole.

A surface of the diamond component on an inlet side of the through hole is preferably a (111) plane, a (100) plane, or a (110) plane. Thereby, it is possible to control the uneven wear of the diamond component during the use of the tool with a through hole and the wear resistance of the diamond component according to the requirements of a drawn material drawn through the through hole.

It is preferable that the diamond component is made of polycrystalline diamond. Thereby, it is possible to suppress the occurrence of chipping and the progress of cracks in the diamond component and the uneven wear of the diamond component during the use of the tool with a through hole.

It is preferable that the tool with a through hole is a die, a water jet nozzle, or a wire guide. The tool with a through hole may have a longer tool life.

A diamond component according to a reference example is provided with a through hole, and when the length of the diamond component along a center line of the through hole is denoted as L1 and the maximum value of a diameter of a circle having the same area as a region surrounded by an outer edge of the diamond component in a cross section having the center line as a normal line is denoted as M1, the ratio L1/M1 between L1 and M1 is 0.8 or more.

Thus, the tool with a through hole including the diamond component may have a longer tool life.

A diamond material according to a reference example is used in a tool with a through hole. In the case where a through hole is formed in the diamond material, and when the length of the diamond material along a center line of the through hole is denoted as L2 and the maximum value of a diameter of a circle having the same area as a cross section of the diamond material having the center line as a normal line is denoted as M2, the ratio L2/M2 between L2 and M2 is 0.8 or more.

Thus, the tool with a through hole manufactured from the diamond material may have a longer tool life.

A diamond material according to a reference example is used in a tool with a through hole, the diamond material is made of single crystal diamond, a first surface of the diamond material is a (111) plane, a (100) plane, or a (110) plane, and when the length of the diamond material along a normal line of the first surface is denoted as L2 and the maximum value of a diameter of a circle having the same area as a cross section of the diamond material parallel to the first surface is denoted as M2, the ratio L2/M2 between L2 and M2 is 0.8 or more.

Thus, the tool with a through hole manufactured from the diamond material may have a longer tool life.

### [Details of Embodiments]

Hereinafter, specific examples of a tool with a through hole according to an embodiment of the present invention will be described with reference to the drawings. Note that the present invention is not defined by these examples but defined by the claims.

In the drawings, the same reference numerals are used to indicate the same or corresponding parts. The dimensions such as the length, width, thickness and depth may be changed appropriately for clarity and simplification of the drawings, and may not be the actual dimensions.

### <First Embodiment: Tool with Through Hole>

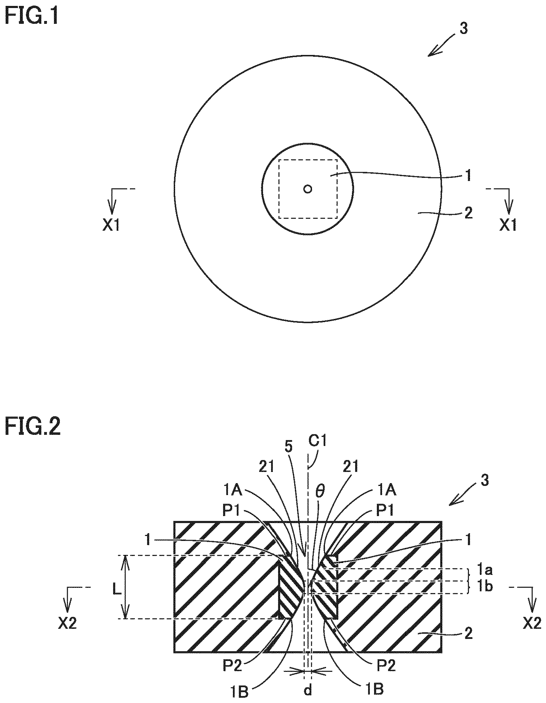

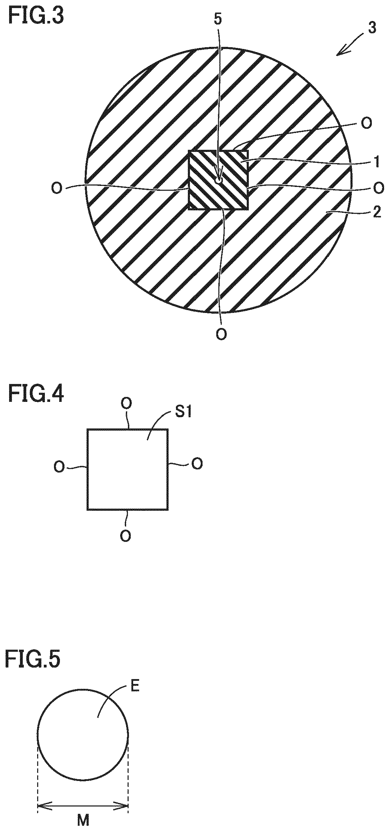

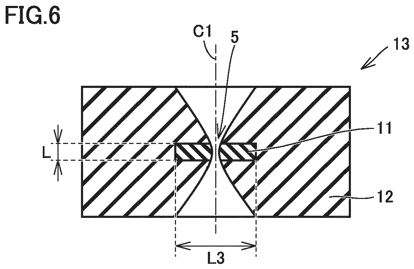

A tool with a through hole according to an embodiment of the present invention will be described with reference to Figs. 1 to 6. Fig. 1 is a plan view of a tool with a through hole according to an embodiment of the present invention. Fig. 2 is a cross-sectional view taken along line X1-X1 of the tool with a through hole illustrated in Fig. 1. Fig. 3 is a cross-sectional view taken along line X2-X2 of the tool with a through hole illustrated in Fig. 2. Fig. 4 is a view illustrating a circle having the same area as a cross section of the diamond component illustrated in Fig. 3. Fig. 6 is a cross-sectional view of a conventional tool with a through hole according to the prior art.

As illustrated in Fig. 1, a tool 3 with a through hole according to the present embodiment includes a base 2 and a diamond component 1 held by the base 2.

(Base)

The base 2 is configured to hold the diamond component 1. As a material of the base 2, a sintered alloy, stainless steel or the like may be used.

The shape of the base 2 is not limited to the shape illustrated in Fig. 1, it may be appropriately changed in accordance with the use of the tool with a through hole.

Although not illustrated in Figs. 1 to 3, a sintered alloy or a filler metal may be provided as a bonding material between the base 2 and the diamond component 1.

### (Diamond Component)

As illustrated in Fig. 2, the diamond component 1 includes an inlet 1A and an outlet 1B. A wire rod to be drawn through the through hole is inserted from the side of the inlet 1A, and drawn out from the side of the outlet 1B as a drawn material. The diamond component 1 includes a first region 1b where the through hole has a minimum diameter d, and a second region 1a which is continuous with the first region 1b and located on the side of the inlet 1A of the through hole.

A through hole 5 is provided in the diamond component 1 and the base 2, continuous from the inlet 1A to the outlet 1B. The through hole 5 is defined by a wall surface 21. The inclination of the wall surface 21 gradually changes with respect to a center line C1 serving as the central axis. In the cross section illustrated in Fig. 2, the center line C1 is a straight line, and the through hole 5 is symmetric in shape with respect to the center line C1.

When the length (indicated by L in Fig. 2) of the diamond component 1 along the center line C1 of the through hole is denoted as L1, and the maximum diameter of a circle having the same area as a region surrounded by an outer edge of the diamond component in a cross section having the center line C1 as the normal line is represented by M1, L1/M1 which is a ratio between L1 and M1 (hereinafter referred to as the ratio L1/M1) is 1.0 or more. In the present specification, the region surrounded by an outer edge of the diamond component 1 in a cross section having the center line C1 as the normal line refers to such a region S1 (see Fig. 4) that is surrounded by an outer edge O (see Figs. 3 and 4) of the diamond component 1 in the cross section and does not include the through hole. Therefore, as illustrated in Fig. 4, the area of the region S1 refers to the entire area of the region surrounded by the outer edge O, including the area corresponding to the through hole. The diameter of the circle having the same area as the region S1 refers to the diameter M of a circle E having the same area as the region S1 (see Fig. 5). The maximum value of the diameter M is denoted as M1.

Since the diamond component 1 has the characteristics described above, the tool with a through hole of the present embodiment may have a longer tool life even if it is used to process a high-strength wire rod at high efficiency. The present inventors infer that the reasons therefor may be present as follows.

One reason that may affect the tool life of a tool with a through hole is the wear of the diamond component during the use of the tool with a through hole. It is considered that the wear includes chemical wear resulting from the graphitization of diamond which is caused by the frictional heat due to the friction between the diamond component and the wire rod to be drawn through the through hole, and mechanical wear which is caused by the friction between the diamond component and the wire rod. According to the tool with a through hole of the present embodiment, since both chemical wear and mechanical wear are suppressed, the tool life thereof is improved. The reasons may be present as follows (i) and (ii):

### (i) Suppression of Chemical Wear

In a conventional tool 13 with a through hole, a diamond component 11 is designed as a plate having a square-shaped main surface. As illustrated in Fig. 6, in the conventional example, the length L1 (indicated by L in Fig. 6) along the center line C1 of the through hole is much shorter than the length L3 in the direction perpendicular to the center line C1 (the horizontal direction in Fig. 6), and the ratio L1/L3 between L1 and L3 is, for example, 0.6 or more and 0.75 or less.

On the contrary, according to the present embodiment, the ratio L1/M1 between the length L1 (indicated by L in Fig. 2) of the diamond component 1 along the center line C1 of the through hole and M1 is 1.0 or more, and the proportion of the length L1 is larger than that of the conventional example.

Therefore, in the conventional example and the present embodiment, when the lengths in the direction perpendicular to the center line C1 of the diamond component (the horizontal direction in Figs. 2 and 6) are the same and the shapes of the through holes are the same, the volume of the diamond component is larger in the present embodiment than that in the conventional example.

Since diamond has high thermal conductivity, if the volume of the diamond component is larger, it is easy to dissipate the frictional heat generated between the diamond component and the wire rod. Therefore, in the diamond component of the present embodiment, the chemical wear resulting from the graphitization of diamond which is caused by the frictional heat is suppressed. As a result, the tool life of the tool with a through hole of the present embodiment is improved.

### (ii) Suppression of Mechanical Wear

One method of suppressing the mechanical wear between the diamond component and the wire rod is to optimize the shape of the through hole. In the conventional diamond component 11, since the length L1 along the center line C1 is short, the degree of freedom in designing the shape of the through hole 5 is limited. Therefore, it is difficult to form a through hole having an optimal shape in the diamond component 11 in practice.

On the contrary, in the diamond component 1 of the present embodiment, when the length in the direction perpendicular to the center line C1 of the diamond component (the horizontal direction in Figs. 2 and 6) is the same as that of the conventional example, the length L1 in the direction along the center line C1 is longer than that of the conventional example. Therefore, in the present embodiment, the degree of freedom in designing the shape of the through hole is greater, which makes it possible to form a through hole having an optimal shape in the diamond component so as to suppress the mechanical wear. As a result, the tool life of the tool with a through hole of the present embodiment is improved.

The ratio L1/M1 between L1 and M1 is 1.0 or more, and preferably 1.3 or more. The upper limit of the ratio L1/M1 is not particularly limited, but is preferably 1.4 or less, for example. In other words, the ratio L1/M1 is 1.0 or more, preferably 1.4 or less, and preferably 1.3 or more and 1.4 or less.

The shape of the surface P1 on the side of the inlet 1A and the shape of the surface P2 on the side of the outlet 1B of the diamond component 1 are not particularly limited, but both may be a square having substantially the same area as the other. In other words, the diamond component 1 may have a prism shape as a whole. In the present specification, the expression that two squares have substantially the same area means that the difference between the areas of two squares is within 5% relative to the smaller area.

When the diamond component 1 has a prism shape as a whole, the ratio L1/D between the length L1 of the diamond component 1 along the center line of the through hole and the length D of one side of the surface P1 or the surface P2 is preferably 0.8 or more. Thus, the wear resistance of the diamond component 1 is improved by the same reason as in the case where the ratio L1/M1 is 1.0 or more.

The ratio L1/D is preferably 1.0 or more, and preferably 1.1 or more. The upper limit of the ratio L1/D is not particularly limited, but is preferably 1.5 or less, for example. In other words, the ratio L1/D is preferably 0.8 or more and 1.5 or less, preferably 1.0 or more and 1.5 or less, and preferably 1.1 or more and 1.5 or less. When the length of one side of the surface P1 and the length of one side of the surface P2 are different from each other, D represents the length of the longer side.

The length L1 of the diamond component 1 along the center line C1 of the through hole is preferably 0.5 mm or more and 50 mm or less, and the maximum value M1 of the diameter of the circle having the same area as the region S1 surrounded by the outer edge of the cross section having the center line C1 as the normal line is preferably 0.5 mm or more and 60 mm or less.

As described above, since the diamond component 1 has a sufficiently large volume, it is excellent in heat dissipation. Therefore, it is possible to suppress the chemical wear of the diamond component. Further, since the length of the diamond component 1 along the center line C1 is sufficiently long, the degree of freedom in designing the through hole is improved. Therefore, it is possible to form a through hole having an optimal shape in the diamond component 1, which makes it possible to suppress the mechanical wear of the diamond component 1.

L1 is more preferably 0.5 mm or more and 50 mm or less, and further preferably 0.5 mm or more and 25 mm or less. M1 is more preferably 0.5 mm or more and 31 mm or less.

The minimum diameter (indicated by d in Fig. 2) of the through hole 5 is preferably 0.001 mm or more and 15 mm or less. The through hole may be made to cope with various diameters, which makes the tool with the through hole highly convenient. The minimum diameter d is more preferably 0.005 mm or more and 10 mm or less, and further preferably 0.01 mm or more and 5 mm or less.

An angle α formed between the surface P1 of the diamond component 1 on the side of the inlet 1A of the through hole 5 and the surface P2 of the diamond component 1 on the side of the outlet 1B of the through hole 5 is preferably 0° or more and 1° or less. Thereby, the diamond component is unlikely to fall down when the diamond component is disposed in the recess of the base during the manufacture of the tool with a through hole, which makes it possible to manufacture the tool with a through hole efficiently. The angle α is more preferably 0° or more and 0.75° or less, and further preferably 0° or more and 0.5° or less.

In the present specification, the angle α (not shown) formed by the surface P1 and the surface P2 refers to an angle formed by a virtual plane P 1' extended from the surface P1 and a virtual plane P2' extended from the surface P2.

The material of the diamond component 1 may be single crystal diamond or polycrystalline diamond.

As examples of single crystal diamonds, natural diamond and synthetic single crystal diamond may be given. The synthetic single crystal diamond may be easily processed into a desired shape, which makes it possible to manufacture a tool with a through hole efficiently, and thus is suitable as a material of the diamond component of the present embodiment. The method of manufacturing the synthetic single crystal diamond is not particularly limited. For example, synthetic single crystal diamond may be manufactured by a high pressure synthesis method or a gas phase synthesis method.

The synthetic single crystal diamond preferably contains nitrogen atoms at a concentration of 0.01 ppb or more and 3000 ppm or less. Thereby, the wear resistance of the tool with a through hole is improved. Further, the synthetic single crystal diamond is unlikely to creak when it is used to manufacture the tool with a through hole. The concentration of nitrogen atoms in the synthetic single crystal diamond is more preferably 0.1 ppm or more and 500 ppm or less, and further preferably 1 ppm or more and 200 ppm or less.

The synthetic single crystal diamond preferably contains boron atoms at a concentration of 0.5 ppb or more and 10000 ppm or less. Thereby, the wear resistance of the tool with a through hole is improved. Further, the synthetic single crystal diamond is unlikely to creak when it is used to manufacture the tool with a through hole. The concentration of boron atoms in the synthetic single crystal diamond is more preferably 0.5 ppb or more and 1 ppm or less, and further preferably 0.5 ppb or more and 0.5 ppm or less.

The synthetic single crystal diamond preferably contains silicon atoms at a concentration of 0.0001 ppb or more and 10000 ppm or less. Thereby, the wear resistance of the tool with a through hole is improved. Further, the synthetic single crystal diamond is unlikely to creak when it is used to manufacture the tool with a through hole. The concentration of silicon atoms in the synthetic single crystal diamond is more preferably 0.003 ppm or more and 100 ppm or less, further preferably 0.01 ppm or more and 50 ppm or less, and even more preferably 0.1 ppm or more and 25 ppm or less.

The synthetic single crystal diamond preferably contains impurity atoms other than nitrogen atoms, boron atoms, and silicon atoms at a total concentration of 0.5 ppb or more and 10000 ppm or less. As examples of the impurity atoms, hydrogen atoms, aluminum atoms, titanium atoms, chromium atoms, copper atoms, tungsten atoms, and iridium atoms may be given. Thereby, the wear resistance of the tool with a through hole is improved. Further, the synthetic single crystal diamond is unlikely to creak when it is used to manufacture the tool with a through hole. The total concentration of impurity atoms in the synthetic single crystal diamond is more preferably 0.5 ppb or more and 5000 ppm or less, and further preferably 0.1 ppm or more and 3000 ppm or less.

The concentration of nitrogen atoms, the concentration of boron atoms, the concentration of silicon atoms, and the concentration of impurity atoms in the synthetic single crystal diamond may be measured by secondary ion mass spectrometry (SIMS). As a measuring device, "IMS 7f" (trade name) manufactured by CAMECA may be used. In the SIMS method, Cs⁺ is used as primary ions, the acceleration voltage is set to 15 kV and the detection region is set to 35 µmϕ to determine the concentration of a spot sputtered at a depth up to 0.5 µm from the outermost surface of a sample. The concentration quantification is performed by comparison with a separately prepared standard sample (single-crystal diamond produced by ion implantation of an impurity at a known concentration). If the impurity concentration is small, the measured value may deviate from a true value depending on the accuracy of the measuring device. In order to obtain a more accurate value, the measurement is performed at a depth of up to 0.5 µm at 5 spots with a distance of at least 100 µm apart from each other, an average value is calculated for 5 values measured at the 5 spots, and the average value is defined as the concentration of each kind of atoms.

The phase difference generated when the synthetic single crystal diamond is irradiated with circularly polarized light is preferably 0.1 nm or more and 200 nm or less. The phase difference of the synthetic single crystal diamond indicates the presence of defects in the synthetic single crystal diamond. When the phase difference falls within the range mentioned above, the amount of defects is controlled within an appropriate range, which makes it possible to suppress the occurrence of chipping in the diamond component during the use of the tool with a through hole. The phase difference is more preferably 10 nm or more and 200 nm or less, and further preferably 30 nm or more and 300 nm or less. The phase difference is measured according to the following steps (a-1) to (a-3).

### (a-1) Preparation of Measurement Sample

The diamond component is processed into a plate shape with a thickness of 700 µm. If the diamond component is thicker, it may be processed by polishing or etching, for example. If the diamond component cannot be processed to a thickness of 700 µm, the phase difference may be measured as described below without processing the diamond component, and the measured value may be converted to a thickness of 700 µm in proportion to the thickness of the diamond component.

### (a-2) Irradiation of Circularly Polarized Light

Circularly polarized light is irradiated from one main surface of the measurement sample prepared in the above (a-1), substantially perpendicular to the main surface.

### (a-3) Measurement of Birefringent Index

10 measurement regions (1x1 mm²) are set on the main surface irradiated with circularly polarized light, and the phase difference is measured in the 10 regions by using "WPA-micro" (trade name) or "WPA-100" (trade name) manufactured by Photonic Lattice, Inc.

An average value is calculated for the measured values of the 10 measurement regions, and the average value is used as the phase difference of the synthetic single crystal diamond.

When the diamond component 1 is made of synthetic single crystal diamond, the surface P1 of the diamond component 1 on the inlet side of the through hole 5 is preferably a (111) plane, a (100) plane or a (110) plane. Thereby, it is possible to control the uneven wear of the diamond component during the use of the tool with a through hole and the wear resistance of the diamond component according to the requirements of the drawn material.

In the case where the surface P1 is a (111) plane, since the uneven wear of the diamond component is unlikely to occur, it is possible to suppress changes on the shape of the through hole during the use of the tool with a through hole. Therefore, the drawn material may have a uniform cross section.

In the case where the surface P1 is a (100) plane, it is easy to polish the diamond component, and thereby it is easy to form the through hole, which is advantageous in manufacturing cost.

In the case where the surface P1 is a (110) plane, the surface roughness of the drawn material (e .g., a drawn wire) after being processed by the tool with a through hole is excellent.

It is preferable that the diamond component is made of polycrystalline diamond. Polycrystalline diamond has excellent hardness but has no hardness orientation or cleavability. Therefore, when polycrystalline diamond is used to prepare the diamond component, it is possible to suppress the occurrence of chipping and the progress of cracks in the diamond component and the uneven wear of the diamond component during the use of the tool with a through hole.

The method of preparing the polycrystalline diamond is not particularly limited. For example, the polycrystalline diamond may be prepared by sintering a carbon material having a graphite layered structure under an ultrahigh temperature and a high pressure without adding any sintering aid or any catalyst.

### <Second Embodiment: Die>

The tool with a through hole according to an embodiment of the present invention may be applied to a die. Since the die can suppress the chemical wear and the mechanical wear caused by the friction between the diamond component and the wire rod, it may have a longer tool life.

### <Third Embodiment: Water Jet Nozzle>

The tool with a through hole according to an embodiment of the present invention may be applied to a water jet nozzle. Since the water jet nozzle can suppress the chemical wear and the mechanical wear caused by the friction between the diamond component and water, it may have a longer tool life.

### <Fourth Embodiment: Wire Guide>

The tool with a through hole according to an embodiment of the present invention may be applied to a wire guide. Since the wire guide can suppress the chemical wear and the mechanical wear caused by the friction between the diamond component and the wire, it may have a longer tool life.

### <Fifth Embodiment: Diamond Component>

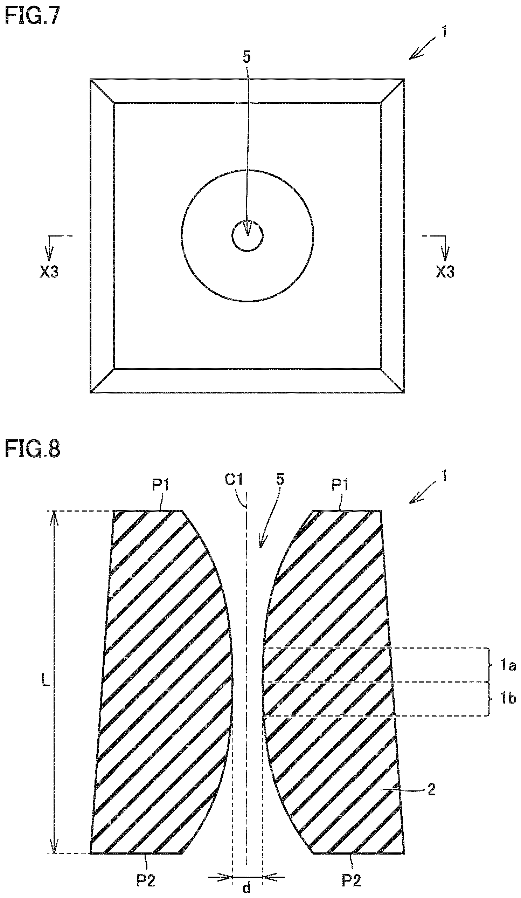

A diamond component according to a reference example will be described with reference to Figs. 7 and 8. Fig. 7 is a plan view of a diamond component according to a reference example. Fig. 8 is a cross-sectional view taken along line X3-X3 of the diamond component illustrated in Fig. 7.

As illustrated in Figs. 7 and 8, the diamond component 1 according to the reference example is a diamond component 1 provided with a through hole 5, and when the length (indicated by L in Fig. 8) of the diamond component 1 along the center line C1 of the through hole 5 is denoted as L1, and the maximum value of the diameter of a circle having the same area as the region S1 surrounded by the outer edge of the diamond component 1 in the cross section having the center line C1 as the normal line is denoted as M1, the ratio L1/M1 between L1 and M1 is 0.8 or more. In Figs. 7 and 8, the shape of the diamond material is illustrated as a truncated quadrangular pyramid, but the shape of the diamond material is not limited to a truncated quadrangular pyramid, and it may be, for example, a quadrangular column, a circular column, a truncated cone or the like as long as the ratio L1/M1 is 0.8 or more.

The tool with a through hole provided with the diamond component may have a longer tool life. The reason is the same as that described in the first embodiment.

The detailed description of the diamond component 1 is the same as that described in the first embodiment, and the description thereof will not be repeated.

### <Sixth Embodiment: Diamond Material (1)>

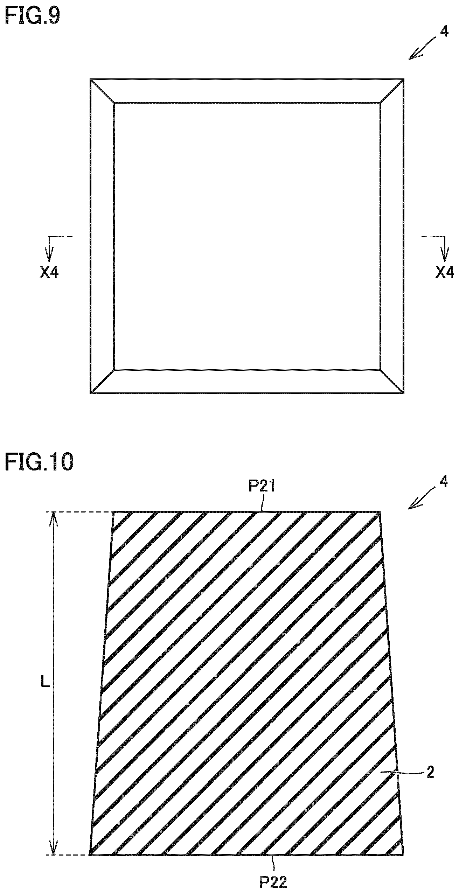

A diamond material according to a reference example will be described with reference to Figs. 9 and 10. Fig. 9 is a plan view of a diamond material according to a reference example. Fig. 10 is a cross-sectional view taken along line X4-X4 of the diamond material illustrated in Fig. 9.

As illustrated in Figs. 9 and 10, the diamond material 4 is a diamond material for use in a tool with a through hole. In the case where a through hole is formed in the diamond material, and when the length (indicated by L in Fig. 10) of the diamond material along the center line of the through hole is denoted as L2 and the maximum value of a diameter of a circle having the same area as a cross section of the diamond material having the center line as a normal line is denoted as M2, L2/M2 which is a ratio between L2 and M2 (hereinafter, referred to as the ratio L2/M2) is 0.8 or more. In Figs. 9 and 10, the shape of the diamond material is illustrated as a truncated quadrangular pyramid, but the shape of the diamond material is not limited to a truncated quadrangular pyramid, and it may be, for example, a quadrangular column, a circular column, a truncated cone or the like as long as the ratio L2/M2 is 0.8 or more.

The diamond component manufactured by forming a through hole in the diamond material 4 may have the same configuration as the diamond component described in the fifth embodiment. Therefore, the tool with a through hole including the diamond component manufactured from the diamond material may have a longer tool life.

### <Seventh Embodiment: Diamond Material (2)>

As illustrated in Figs. 9 and 10, the diamond material 4 is a synthetic single crystal diamond material for use in a tool with a through hole, a first surface of the synthetic single crystal diamond material is a (111) plane, a (100) plane, or a (110) plane, and when the length (indicated by L in Fig. 10) of the diamond material along a normal line of the first surface is denoted as L2 and the maximum value of a diameter of a circle having the same area as a cross section of the diamond material parallel to the first surface is denoted as M2, the ratio L2/M2 between L2 and M2 is 0.8 or more. The diamond component manufactured by forming a through hole in the diamond material 4 parallel to the normal line of the first surface may have the same configuration as the diamond component described in the fifth embodiment. Therefore, the tool with a through hole including the diamond component manufactured from the diamond material may have a longer tool life.

### <Eighth Embodiment: Method of Manufacturing Tool with Through Hole (1)>

An example method of manufacturing a tool with a through hole according to an embodiment of the present invention will be described. In the present embodiment, the diamond component is made of synthetic single crystal diamond. The method of manufacturing a tool with a through hole of the present embodiment includes a step of preparing synthetic single crystal diamond (hereinafter also referred to as "the synthetic single crystal diamond preparing step"), a step of preparing a diamond material (hereinafter also referred to as "the diamond material preparing step"), and a step of manufacturing a tool with a through hole (hereinafter also referred to as "the tool with a through hole manufacturing step").

### (Synthetic Single Crystal Diamond Preparing Step)

The synthetic single crystal diamond is prepared by using, for example, a high pressure synthesis method or a chemical vapor deposition (CVD) method. Since the concentration of nitrogen atoms, the concentration of boron atoms, the concentration of silicon atoms, the concentration of impurity atoms and the amount of defects in the synthetic single crystal diamond may be easily controlled in the CVD method, the CVD method is preferred.

In the CVD method, single crystal diamond is grown on a seed substrate that is disposed on a substrate holder in a CVD growth furnace. As the growth method, any conventionally known method such as a thermal filament method, a combustion flame method, or an arc jet method may be used.

The concentration of nitrogen atoms, the concentration of boron atoms, the concentration of silicon atoms, and the concentration of impurity atoms in the synthetic single crystal diamond may be adjusted by the ratio of source gas, the components in the growth furnace, the growth temperature, and the like.

The amount of defects in the synthetic single crystal diamond may be adjusted by the surface roughness, the surface pre-treatment and the like of the seed substrate.

### (Diamond Material Preparing Step)

The single crystal diamond formed on the seed substrate is cut by laser into a desired shape to prepare a diamond material. The single crystal diamond may be cut into the diamond material with a desired thickness by adjusting the interval (distance) of laser irradiations on the single crystal diamond. This thickness corresponds to the length L2 along the center line of the through hole in the diamond material described in the sixth embodiment, or the length L2 along the normal line to the first surface in the diamond material described in the seventh embodiment, or the length of one side of the first surface P21 (the upper surface in Fig. 10) or the second surface P22 substantially parallel to the first surface. These lengths are maintained in the subsequent steps. Therefore, the length L2 of the diamond material is the same as the length L1 along the center line of the through hole in the diamond component, and the length of one side of the first surface P21 or the second surface P22 in the diamond material is the same as the length of one side of the surface P1 or the surface P2 in the diamond component.

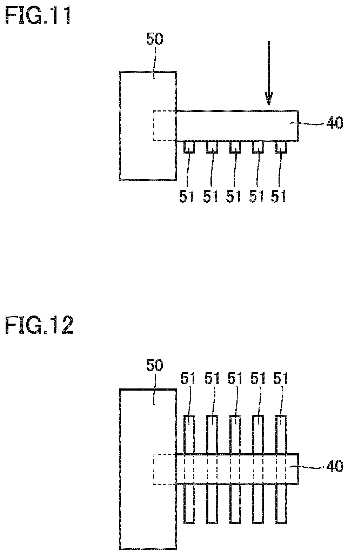

In the present embodiment, a slit-type cutting assist jig 51 as illustrated in Figs. 11 and 12 is used in the laser cutting.

Conventionally, in the laser cutting, the synthetic single crystal diamond is cut by laser while one end thereof is supported by a cutting jig 50 in a floated state. In the conventional method, in order to prevent the reflection of laser beam, a cutting assist jig 51 is not used to support the synthetic single crystal diamond from the below. Therefore, when it is attempted to cut a thick diamond material from the synthetic single crystal diamond, the end (to be cut out) which is not supported by the cutting jig 50 may break by its own weight during the cutting, which causes the occurrence of burrs.

If burrs are present in the diamond material, the diamond material may become unstable when it is placed in a recess of the base in the subsequent step, and thus, the burrs are eliminated by polishing. Therefore, in the conventional cutting method, due to the addition of the polishing step, the manufacturing cost is increased, and the productivity is decreased.

On the contrary, in the present embodiment, one end of the synthetic single crystal diamond is supported by the cutting jig 50, and the slit-type cutting assist jig 51 is disposed below the synthetic single crystal diamond to support the same from the below, and the laser cutting is performed while the synthetic single crystal diamond is being supported from the below. Since the laser beam to be irradiated will pass through the slits, no laser beam is reflected. Since the synthetic single crystal diamond is supported on the cutting assist jig 51, even if a thick diamond material is cut from the synthetic single crystal diamond, the synthetic single crystal diamond will not break during the cutting. Therefore, it is possible to prevent burrs from occurring in the obtained diamond material.

The laser used in the cutting may have, for example, a wavelength of 532 nm, a repetition frequency of 6 kHz or more and 10 kHz or less, and an output of 3 W or more and 20 W or less.

### (Tool with Through Hole Manufacturing Step)

The obtained diamond material is placed in the recess of the base together with a bonding material such as powder of sintered alloy, and subjected to a heat treatment to melt the bonding material, and thereby, the diamond material and the base are bonded to each other to form a bonded body.

A through hole is formed in the bonded body by laser irradiation, whereby a tool with a through hole including the diamond component is manufactured.

<Ninth Embodiment: Method of Manufacturing Tool with Through Hole (2)>

An example method of manufacturing a tool with a through hole according to an embodiment of the present invention will be described. In the present embodiment, the diamond component is made of polycrystalline diamond. The method of manufacturing a tool with a through hole of the present embodiment includes a step of preparing polycrystalline diamond (hereinafter also referred to as "the polycrystalline diamond preparing step"), a step of preparing a diamond material (hereinafter also referred to as "the diamond material preparing step"), and a step of manufacturing a tool with a through hole (hereinafter also referred to as "the tool with a through hole manufacturing step").

### (Polycrystalline Diamond Preparing Step)

The polycrystalline diamond is prepared, for example, by sintering a carbon material having a graphite layered structure under an ultrahigh temperature and a high pressure without adding any sintering aid or any catalyst.

Subsequently, the diamond material preparing step and the tool with a through hole manufacturing step are carried out in the same manner as those described in the eighth embodiment, whereby a tool with a through hole including the diamond component is manufactured.

### Example

The embodiments of the present invention will be described in more details with reference to an example. However, the present invention is not limited by the example.

In the example, a tool with a through hole (such as a die) in which a diamond component is made of synthetic single crystal diamond was manufactured and evaluated. The specific manufacturing method and the evaluation method are described in the following.

### <Preparation of Synthetic Single Crystal Diamond>

Synthetic single crystal diamond was prepared by the CVD method. First, a single crystal diamond seed substrate having a square-shaped main surface of 5 × 5 mm² and a thickness of 0.5 mm was prepared. The seed substrate was polished plat, and then as a pretreatment for controlling the defects in the synthetic single crystal diamond, the seed substrate was dry etched to a depth of 0.01 µm to 0.5 µm using oxygen (O₂) gas and hydrogen fluoride (CF₄) gas. An epitaxial growth layer was grown from the single crystal diamond on the substrate to a thickness of 1 mm. A mixed gas of hydrogen (H₂) gas, methane (CH₄) gas and nitrogen (N₂) gas was used as the source gas. The volume ratio of CH₄ gas to H₂ gas (CH₄ gas/H₂ gas) was set to 5 to 20 vol%, and the volume ratio of N₂ gas to CH₄ gas (N₂ gas/CH₄ gas) was set to 0.01 to 5 vol%. The pressure was set to 9.3 to 14.7 kPa, and the temperature of the substrate was set to 850 to 1200°C. The concentration of impurities in the synthetic single crystal diamond may be adjusted by the ratio of source gas, the components in the growth furnace, the growth temperature and the like, and the amount of defects in the synthetic single crystal diamond may be adjusted by the surface roughness of the single crystal diamond seed substrate, damages to the polishing layer and the like.

### <Measurement of Synthetic Single Crystal Diamond>

The concentration of nitrogen atoms, the concentration of boron atoms, the concentration of silicon atoms, the total concentration of impurity atoms, and the phase difference of the obtained synthetic single crystal diamond were measured. The measurement methods are the same as those described in the first embodiment. The results are shown in Table 1.

### <Preparation of Diamond Material>

The single crystal diamond prepared as described above was supported by a cutting jig and a slit-type cutting assist jig as illustrated in Figs. 11 and 12, and cut by laser to produce a diamond material having a quadrangular prism shape with a square-shaped bottom surface and a square-shaped upper surface.

The thickness (height) L2 of the diamond material and the length D2 of one side of the bottom surface and the upper surface of the diamond material were measured for each sample. The values of "L2" and "D2" are maintained in the subsequent steps. Therefore, the values of "L2" and "D2" of the diamond material are the same as the values of the length "L1" of the diamond component along the center line C1 of the through hole in the tool manufactured from the diamond material and the length "D" of one side of the bottom surface and the upper surface of the diamond component, respectively. Thus, the values of "L2" and "D2" measured from the diamond material are listed in the columns of "L1" and "D" of the diamond component in Table 1.

The diameter M of the circle having the same area as the bottom surface and the upper surface was calculated from the value of "D". Since the shape of the diamond material for each sample is a quadrangular prism, the value of "M" corresponds to the maximum value M1 of the diameter of the equal-area circle. Thus, the calculated value of "M" is listed in the column of "M1" of the diamond component in Table 1.

In all the samples, the angle α between the bottom surface and the upper surface of the diamond material was 0.5° or less. In samples 1 to 6 and samples 8 to 11, the bottom surface and the upper surface were (110) planes. In Sample 7, the bottom surface and the upper surface were (111) planes.

### <Production of Tool with Through Hole>

The obtained diamond material was placed in a recess of the base (made of sintered alloy) so that the bottom surface of the diamond material was substantially parallel to the bottom surface of the recess. At this time, a spray was applied as an adhesive between the bottom surface of the recess and the diamond material so as to prevent the diamond material from inclining. Thereafter, a bonding material made of sintered alloy powder was placed between the diamond material and the recess, and subjected to a heat treatment to melt the bonding material, and thereby, the diamond material and the base are bonded to each other to form a bonded body.

A through hole continuous from the upper surface to the bottom surface of the diamond material was formed in the bonded body by laser irradiation to produce a tool with a through hole. Thus, the upper surface of the diamond material becomes the surface P1 on the inlet side of the through hole, and the bottom surface becomes the surface P2 on the outlet side of the through hole. The minimum diameter d of the through hole was 0.080 mm, the length of the first region along the center line was 16 µm, and the angle θ between the wall surface of the diamond component defining the second region and the center line was 12°.

### <Drawing Test>

The obtained tool with a through hole was used to perform a drawing test on a wire rod (diameter ϕ: 86.63 µm, material: stainless steel (SUS304)). A synthetic oil lubricant was used during the wire drawing. The drawing speed was 500 m/min, and the area reduction rate was 14%.

The wire was drawn to 15 km under the above conditions, and after the drawing, the minimum value of the diameter of the through hole was measured, and the increment of the minimum value per unit time (µm/min) was defined as the wear rate. The smaller the wear rate is, the better the wear resistance is. The results are shown in Table 1. Sample Nos. 1 and 2 are reference examples.

**Table 1**

| Sample No. | Diamond Component | | | | | Diamond Component | | | | | | Wear Rate (µm/min) |
|---|---|---|---|---|---|---|---|---|---|---|---|---|
| | Shape | | | | | Properties | | | | | | |
| | L1 | D | M1 | Ll/M1 | L1/D | surface P1 | nitrogen | silicon | boron | impurity | phase | |
| | (mm) | (mm) | (mm) | | | orientation | atoms | atoms | atoms | atoms | difference | |
| | | | | | | | (ppm) | (ppm) | (ppm) | (ppm) | (nm) | |
| 1 | 0.6 | 0.8 | 0.903 | 0.665 | 0.75 | (110) | 0.2 | 0.004 | 0.003 | <0.005 | 30 | 0.04 |
| 2 | 0.8 | 0.8 | 0.903 | 0.886 | 1 | (110) | 5 | 0.9 | 0.001 | 28.4 | 71 | 0.017 |
| 3 | 0.9 | 0.8 | 0.903 | 0.997 | 1.125 | (110) | 0.1 | 0.004 | 0.002 | 2.1 | 68 | 0.011 |
| 4 | 0.9 | 0.8 | 0.903 | 0.997 | 1.125 | (110) | 2 | 1.4 | 0.0009 | 91 | 81 | 0.013 |
| 5 | 0.9 | 0.8 | 0.903 | 0.997 | 1.125 | (110) | 5 | 0.9 | 0.001 | 28.4 | 71 | 0.013 |
| 6 | 0.9 | 0.8 | 0.903 0.8 | 0.997 | 1.125 | (110) | 24 | 3 | 0.009 | 540 | 80 | 0.015 |
| 7 | 0.9 | 0.8 | 0.903 | 0.997 | 1.125 | (110) | 21 | 2.7 | 0.009 | 570 | 76 | 0.009 |
| 8 | 0.9 | 0.8 | 0.903 | 0.997 | 1.125 | (110) | 100 | 0.05 | 0.003 | 2100 | 76 | 0.02 |
| 9 | 0.9 | 0.8 | 0.903 | 0.997 | 1.125 | (110) | 220 | 0.9 | 0.002 | 2540 | 80 | 0.035 |
| 10 | 1.2 | 0.8 | 0.903 | 1.329 | 1.5 | (110) | 50 | 0.023 | 0.0006 | 1989 | 73 | 0.012 |
| 11 | 1.2 | 0.8 | 0.903 | 1.329 | 1.5 | (110) | 150 | 0.07 | 0.001 | 2250 | 80 | 0.015 |

### <Evaluation>

The ratio L1/M1 was 0.665 for sample 1 which serves as a comparative example. The ratio L1/M1 was 0.8 or more for samples 2 to 11, each of which serves as an example. It was confirmed that samples 2 to 11 (examples) showed excellent wear resistance in processing a high-strength wire rod at high efficiency as compared with sample 1 (comparative example).

Embodiments and specific examples of the present invention are described above.

It should be understood that the embodiments disclosed herein have been presented for the purpose of illustration and description but not limited in all aspects. It is intended that the scope of the present invention is not limited to the description above but defined by the scope of the claims.

### REFERENCE SIGNS LIST

1, 11: diamond component; 2, 12: base; 3, 13: tool with through hole; 4: diamond material; 5: through hole; 21: wall surface; 1a: second region; 1b: first region; 1A: inlet; 1B: outlet; O: outer edge; L: length along center line C1; P1: surface on inlet side; P2: surface on outlet side

## Claims

1. A tool with a through hole (3) comprising:
a base (2); and
a diamond component (1) held by the base (2), the diamond component (1) being made of synthetic single crystal diamond or polycrystalline diamond,
**characterised in that** when the length of the diamond component (1) along a center line of the through hole (5) is denoted as L1, and the maximum value of a diameter of a circle having the same area as a region surrounded by an outer edge (O) of the diamond component (1) in a cross section having the center line as a normal line is denoted as M1, the ratio L1/M1 between L1 and M1 being 1.0 or more.

2. The tool with a through hole (3) according to claim 1, wherein
L1 is 0.5 mm or more and 50 mm or less, and
M1 is 0.5 mm or more and 31 mm or less.

3. The tool with a through hole (3) according to claim 1 or 2, wherein
the minimum diameter of the through hole (5) is 0.001 mm or more and 15 mm or less.

4. The tool with a through hole (3) according to any preceding claim, wherein
the diamond component (1) is made of synthetic single crystal diamond and the synthetic single crystal diamond contains nitrogen atoms at a concentration of 0.01 ppb or more and 3000 ppm or less.

5. The tool with a through hole (3) according to any preceding claim, wherein
the diamond component (1) is made of synthetic single crystal diamond and the synthetic single crystal diamond contains boron atoms at a concentration of 0.5 ppb or more and 10000 ppm or less.

6. The tool with a through hole (3) according to any preceding claim, wherein
the diamond component (1) is made of synthetic single crystal diamond and the synthetic single crystal diamond contains silicon atoms at a concentration of 0.0001 ppb or more and 10000 ppm or less.

7. The tool with a through hole (3) according to any preceding claim, wherein
the diamond component (1) is made of synthetic single crystal diamond and the synthetic single crystal diamond contains impurity atoms other than nitrogen atoms, boron atoms and silicon atoms at a total concentration of 0.5 ppb or more and 10000 ppm or less.

8. The tool with a through hole (3) according to any preceding claim, wherein
the diamond component (1) is made of synthetic single crystal diamond and the phase difference generated when the synthetic single crystal diamond is irradiated with circularly polarized light is 0.1 nm or more and 200 nm or less.

9. The tool with a through hole (3) according to any preceding claim, wherein
the diamond component (1) is made of synthetic single crystal diamond and a surface of the diamond component (1) on an inlet side of the through hole (5) is a (111) plane, a (100) plane, or a (110) plane.

10. The tool with a through hole (3) according to any one of claims 1 to 9, wherein
the tool with a through hole (3) is a die, a water jet nozzle, or a wire guide.

## Patentansprüche

1. Werkzeug mit einem Durchgangsloch (3), umfassend:
eine Basis (2); und
eine von der Basis (2) gehaltene Diamantkomponente (1), wobei die Diamantkomponente (1) aus einem synthetischen Einkristalldiamant oder polykristallinen Diamant besteht,
**dadurch gekennzeichnet, dass,** wenn die Länge der Diamantkomponente (1) entlang einer Mittelinie des Durchgangslochs (5) als L1 bezeichnet ist und der Maximalwert eines Durchmessers eines Kreises mit der gleichen Fläche wie ein von einem Außenrand (O) der Diamantkomponente (1) in einem Querschnitt mit der Mittellinie als eine Normallinie umgebener Bereich als M1 bezeichnet ist, das Verhältnis L1/M1 zwischen L1 und M1 1,0 oder mehr beträgt.

2. Werkzeug mit einem Durchgangsloch (3) nach Anspruch 1, wobei L1 0,5 mm oder mehr und 50 mm oder weniger beträgt, und
M1 0,5 mm oder mehr und 31 mm oder weniger beträgt.

3. Werkzeug mit einem Durchgangsloch (3) nach Anspruch 1 oder 2, wobei
der Mindestdurchmesser des Durchgangslochs (5) 0,001 mm oder mehr und 15 mm oder weniger beträgt.

4. Werkzeug mit einem Durchgangsloch (3) nach einem der vorhergehenden Ansprüche, wobei die Diamantkomponente (1) aus einem synthetischen Einkristalldiamant besteht und der synthetische Einkristalldiamant Stickstoffatome in einer Konzentration von 0,01 ppb oder mehr und 3000 ppm oder weniger enthält.

5. Werkzeug mit einem Durchgangsloch (3) nach einem der vorhergehenden Ansprüche, wobei die Diamantkomponente (1) aus einem synthetischen Einkristalldiamant besteht und der synthetische Einkristalldiamant Boratome in einer Konzentration von 0,5 ppb oder mehr und 10000 ppm oder weniger enthält.

6. Werkzeug mit einem Durchgangsloch (3) nach einem der vorhergehenden Ansprüche, wobei die Diamantkomponente (1) aus einem synthetischen Einkristalldiamant besteht und der synthetische Einkristalldiamant Siliciumatome in einer Konzentration von 0,0001 ppb oder mehr und 10000 ppm oder weniger enthält.

7. Werkzeug mit einem Durchgangsloch (3) nach einem der vorhergehenden Ansprüche, wobei die Diamantkomponente (1) aus einem synthetischen Einkristalldiamant besteht und der synthetische Einkristalldiamant andere Fremdatome wie Stickstoffatome, Boratome und Siliciumatome in einer Gesamtkonzentration von 0,5 ppb oder mehr und 10000 ppm oder weniger enthält.

8. Werkzeug mit einem Durchgangsloch (3) nach einem der vorhergehenden Ansprüche, wobei die Diamantkomponente (1) aus einem synthetischen Einkristalldiamant besteht und der erzeugte Phasenunterschied, wenn der synthetische Einkristalldiamant mit zirkular polarisiertem Licht bestrahlt wird, 0,1 nm oder mehr und 200 nm oder weniger beträgt.

9. Werkzeug mit einem Durchgangsloch (3) nach einem der vorhergehenden Ansprüche, wobei die Diamantkomponente (1) aus einem synthetischen Einkristalldiamant besteht und eine Fläche der Diamantkomponente (1) an einer Eingangsseite des Durchgangslochs (5) eine (111)-Ebene, eine (100)-Ebene oder eine (110)-Ebene ist.

10. Werkzeug mit einem Durchgangsloch (3) nach einem der Ansprüche 1 bis 9, wobei
das Werkzeug mit einem Durchgangsloch (3) ein Gesenk, eine Wasserstrahldüse oder eine Drahtführung ist.

## Revendications

1. Outil avec une perforation (3) comprenant :
une base (2) ; et
un constituant en diamant (1) supporté par la base (2), le constituant en diamant (1) étant constitué de diamant monocristallin ou diamant polycristallin synthétique,
**caractérisé en ce que** lorsque la longueur du constituant en diamant (1) le long d'une ligne centrale de la perforation (5) est indiquée par L1, et la valeur maximum d'un diamètre d'un cercle ayant la même surface qu'une région entourée par un bord externe (O) du constituant en diamant (1) dans une section transversale ayant la ligne centrale comme une ligne perpendiculaire est indiquée par M1, le rapport L1/M1 entre L1 et M1 est de 1,0 ou supérieur.

2. Outil avec une perforation (3) selon la revendication 1, dans lequel
L1 est de 0,5 mm ou supérieur et 50 mm ou inférieur, et
M1 est de 0,5 mm ou supérieur et 31 mm ou inférieur.

3. Outil avec une perforation (3) selon la revendication 1 ou 2, dans lequel
le diamètre minimum de la perforation (5) est de 0,001 mm ou supérieur et 15 mm ou inférieur.

4. Outil avec une perforation (3) selon l'une quelconque des revendications précédentes, dans lequel
le constituant en diamant (1) est constitué de diamant monocristallin synthétique et le diamant monocristallin synthétique contient des atomes d'azote à une concentration de 0,01 ppb ou supérieure et 3 000 ppm ou inférieure.

5. Outil avec une perforation (3) selon l'une quelconque des revendications précédentes, dans lequel
le constituant en diamant (1) est constitué de diamant monocristallin synthétique et le diamant monocristallin synthétique contient des atomes de bore à une concentration de 0,5 ppb ou supérieure et 10 000 ppm ou inférieure.

6. Outil avec une perforation (3) selon l'une quelconque des revendications précédentes, dans lequel
le constituant en diamant (1) est constitué de diamant monocristallin synthétique et le diamant monocristallin synthétique contient des atomes de silicium à une concentration de 0,0001 ppb ou supérieure et 10 000 ppm ou inférieure.

7. Outil avec une perforation (3) selon l'une quelconque des revendications précédentes, dans lequel
le constituant en diamant (1) est constitué de diamant monocristallin synthétique et le diamant monocristallin synthétique contient des atomes d'impuretés différents des atomes d'azote, atomes de bore et atomes de silicium à une concentration totale de 0,5 ppb ou supérieure et 10 000 ppm ou inférieure.

8. Outil avec une perforation (3) selon l'une quelconque des revendications précédentes, dans lequel
le constituant en diamant (1) est constitué de diamant monocristallin synthétique et la différence de phase produite lorsque le diamant monocristallin synthétique est irradié avec de la lumière polarisée de manière circulaire est de 0,1 nm ou supérieure et 200 nm ou inférieure.

9. Outil avec une perforation (3) selon l'une quelconque des revendications précédentes, dans lequel
le constituant en diamant (1) est constitué de diamant monocristallin synthétique et une surface du constituant en diamant (1) sur un côté d'entrée de la perforation (5) est un plan (111), un plan (100), ou un plan (110).

10. Outil avec une perforation (3) selon l'une quelconque des revendications 1 à 9, dans lequel
l'outil avec une perforation (3) est une filière, une buse pour jet d'eau, ou un guide fil.
